## Europäisches Patentamt
## European Patent Office
## Office européen des brevets

(19)

(11) Veröffentlichungsnummer: **0 151 251**
**B1**

(12) **EUROPÄISCHE PATENTSCHRIFT**

(45) Veröffentlichungstag der Patentschrift:
01.03.89

(51) Int. Cl.⁴: **B 23 B 51/02**

(21) Anmeldenummer: **84114630.1**

(22) Anmeldetag: **01.12.84**

(54) **Mehrschneidenbohrer.**

(30) Priorität: **09.12.83 DE 3344620**

(43) Veröffentlichungstag der Anmeldung:
**14.08.85 Patentblatt 85/33**

(45) Bekanntmachung des Hinweises auf die Patenterteilung:
**01.03.89 Patentblatt 89/9**

(84) Benannte Vertragsstaaten:
**AT CH DE FR GB IT LI**

(56) Entgegenhaltungen:
**DE-U- 7 710 873**
**FR-A- 873 752**
**US-A- 2 334 089**
**US-A- 4 143 723**

**TECHNISCHE RUNDSCHAU, Band 68, Nr. 46, November 1976, Seiten 7-12, Hallwag Verlag, Bern, CH; K. Häuser: "Bohrerspitzen zum Bearbeiten von Blech" Idem**

(73) Patentinhaber: **HARTMETALLWERKZEUGFABRIK ANDREAS MAIER GMBH + CO KG, Stegwiesen 2, D-7959 Schwendi-Hörenhausen (DE)**

(72) Erfinder: **Maier, Andreas, Stegwiesen 2, D-7959 Schwendi-Hörenhausen (DE)**

(74) Vertreter: **Braito, Herbert, Dipl.-Ing., Postfach 1140 Martin-Luther-Strasse 1, D-7950 Biberach/Riss 1 (DE)**

## Beschreibung

Die Erfindung betrifft einen Mehrschneidenbohrer mit wenigstens drei von einem Bohrerkern aus vorwiegend radial verlaufenden Stirnschneiden, die jeweils durch eine Schneidspitze unterteilt sind in eine zur Bohrerachse nach innen/vorn geneigte Außenschneide und eine nach innen/hinten geneigte Innenschneide, mit an der Bohrerstirn angebrachten zusätzlichen Zentriermitteln, insbesondere zum Bohren von Werkstücken mit hoher, jedoch wechselnder Härte und Festigkeit wie faserverstärkte Leiterplatten.

Bei Bohrern, insbesondere Spiralbohrern mit zwei Stirnschneiden, kommt in der Regel eine einzige, in der Bohrerachse liegende Zentrierspitze mit einer Querschneide in Betracht. Die ungünstige Schneidengeometrie der Querschneide hat starke Reibung zur Folge, erhöht dadurch die Vorschubkraft und erleichtert das radiale Abdrängen.

Bekannt sind auch Spiralbohrer mit drei Schneidlippen, die mit weitgehend geradlinigen Stirnschneiden in einer einzigen kegelförmigen Spitze enden. Da Dreischneiden-Bohrer notwendigerweise größeren Kerndurchmesser haben als Zweischneiden-Bohrer, müssen die Stirnschneiden bis in den Kern hineinverlängert werden, d.h. die Schneidlippen werden «ausgespitzt», bzw. aus den Spannuten werden gesonderte Spitznuten in den kegelförmigen Endteil weitergeführt. Bohrer dieser Art haben zwar auch hinreichende Zentriereigenschaft und Laufruhe, führen aber zu Spanquerschnitten, die vor allem bei langspanenden Werkstoffen zu Problemen beim Spantransport in den Spannuten führen.

Bei anderen Konstruktionen ist jede Stirnschneide mit einer exzentrisch zur Bohrerachse angeordneten Schneidspitze versehen, die meist mit Innenschneide und Außenschneide auf der gleichen Umlauffläche liegt, so daß beim Einfahren in das Werkstück alle drei Stirnschneiden im Bereich der Schneidspitzen und daher mit einem vorgegebenen Hebelarm zur Einwirkung kommen. Auf diese Weise läßt sich die Bohrleistung wesentlich steigern, auch die Stabilität gegen seitliche Abdrängkräfte wird verbessert. Die wirksamen Abdrängkräfte resultieren aus unterschiedlichen Schnittkräften pro Schneide. Diese Schnittkräfte sind zwar bei absolut gleicher Symmetrie und Ausbildung der Schneiden ausgeglichen, aber das ist in der Praxis kaum zu verwirklichen. Daher müssen die verbleibenden Radialkräfte entweder durch gesonderte Führungsleisten oder an den Nebenschneiden aufgenommen werden.

Bei derartigen Dreischneidenbohrern wurden als Zentriermittel in die Hauptschneiden schon achsparallele Absätze eingeformt, die eine Zylinderfläche in das Werkstück schneiden (DE-GM 77 10 873). Auf diese Weise kann aber nur eine sehr begrenzte Laufberuhigung erzielt werden, wenn der Bohrer schon über eine größere Strecke in das Werkstück eingedrungen ist. Dabei kann bei harten Werkstoffen oder Werkstoffen mit regelmäßiger oder unregelmäßiger Härteverteilung das Verlaufen des Bohrers beim Anschnitt nicht verhindert werden, und dies hat neben Maßungenauigkeit bleibende Unrundheit der Bohrung und ungewöhnlich große Querbelastung des Bohrers zur Folge. Dies wirkt sich vor allem bei sehr dünnen Bohrern, etwa in der Größenordnung um 0,2 mm Durchmesser oder darunter nachteilig aus. Vornehmlich Werkstücke aus unterschiedlichen Werkstoffkomponenten, die unter Umständen noch unregelmäßig verteilt sind, bringen erhöhte Bruchgefahr für das Werkzeug.

Die Erfindung befaßt sich insbesondere mit dem automatischen Bohren von Leiterplatten für elektrische und elektronische Geräte. Solche Leiterplatten werden im automatischen Betrieb mit einer Vielzahl Bohrungen mit Durchmessern bis etwa 3,2 mm versehen. Dabei ist die Beanspruchung der Bohrer vor allem deshalb hoch, weil ein relativ weicher Füllwerkstoff, in der Regel Kunststoff, Verstärkungsfasern aus vielfach härterem Werkstoff, Glasfasern oder Kohlenstoffasern umschließt. Dort trifft der sehr dünne Bohrer aus dem weichen Füllwerkstoff wiederholt und plötzlich auf die harte Faser. Außer der Torsionsbeanspruchung ist damit eine Auslenktendenz zur Seite und damit eine Biegeeinwirkung verbunden, die schlagartig aufgebracht leicht zur Zerstörung des Bohrers führen kann. Auslenkgefahr und Biegebeanspruchung sind umso größer, je geringer Zentriergenauigkeit und Rundlaufgenauigkeit des Bohrers sind.

In der Leiterplatten-Herstellung werden deshalb beim Erstellen von Bohrungen im Durchmesserbereich bis 3,175 mm nachstehende Anforderungen gestellt:

1. Höchste Positionsgenauigkeit sowohl beim Eintritt als auch beim Austritt. Kein Verlaufen des Bohrers.

2. An der Ein- und Austrittseite gratfreie Bohrungen.

3. Saubere Bohrungen ohne Verklebungen oder Anschmelzungen.

4. Absolute Rundheit der Bohrungen.

Daraus ergeben sich für das Bohrwerkzeug zur Herstellung von Löchern in der Leiterplatten-Fertigung die nachstehenden Anforderungen:

a) sehr gute Zentriereigenschaften,
b) scharfe Schneiden und exakt ausgelegte Schneidengeometrie,
c) geringe Reibung der Bohrungswandung,
d) guter Spänetransport,
e) hohe Rundlaufgüte,
f) hohe Laufruhe,
g) hohe Standzeit, bzw. geringer Verschleiß.

Die Erfindung geht aus von dem eingangs definierten Mehrschneidenbohrer und verfolgt die Aufgabe, den Bohrer bei möglichst großer Schnittleistung so zu gestalten, daß er exakt zentriert in das Werkstück eintritt und in diesem geführt wird, um auch bei ungünstigen harten Werkstücken oder Werkstücken mit unterschiedlich harten, flächenmäßig verteilten Werkstoffkomponenten geringe Biegebeanspruchung und hohe Standzeit zu erzielen.

Zur Lösung dieser Aufgabe weisen erfindungsgemäß die Zentriermittel eine aus dem Bohrerkern herausgeformte, hinter die Schneidspitzen zurückversetzte Zentrierspitze auf, zu der die als Zentrumsschneiden ausgebildeten innersten Teile wenigstens einer Stirnschneide geführt sind.

Durch die vorstehenden Schneidspitzen der abgeknickten Hauptschneiden, die auch die Anzentrierung übernehmen, werden die Späne an der Hauptschneide unterteilt. Dabei kann an der Außenschneide ein positiver Spanwinkel beibehalten werden, der ein sauberes, gratfreies An- und Ausschneiden gewährleistet, zumal die Neigung an den Außenecken eine leichte radiale Ablösung des Spanes vom Werkstück und einen Transport nach innen in die Spannut bewirkt. Der Querschnitt dieser Spannut läßt sich dabei weitgehend der hauptsächlich außen abgetragenen Spanmenge anpassen, was mit geringer Reibung ohne Verklebungen und Verschmelzungen erreicht wird.

Auch an der Innenschneide kann wenigstens im äußeren Teil ein positiver Spanwinkel beibehalten werden, aber zur Zentrumsschneide, insbesondere zur Zentrierspitze hin läßt sich nur ein negativer Spanwinkel einrichten. Dadurch verursacht wird der Schnittwiderstand ebenso wie der Vorschubwiderstand vergrößert. Mit dem höheren Schnittdruck bewirkt die gegenüber den Schneidspitzen zurückversetzte Zentrierspitze einen zusätzlichen Stabilisierungseffekt, der einen ruhigen Rundlauf des Werkzeuges ohne Eigenschwingungen zur Folge hat und dadurch das Herstellen gratfreier und exakt runder Bohrungen. Auf diese Weise wird neben einer Verbesserung der Positioniergenauigkeit vor allem eine Verringerung der Bohrerbelastung erzielt. Insbesondere wird nach Erreichen einer begrenzten Eindringtiefe den vom Werkstück her ausgeübten Querkräften entgegengewirkt und damit Verschleiß und Bruchgefährdung des Bohrers herabgesetzt.

Selbst bei einem Angriff an einem härteren Werkstoffelement wie einer Glasfaser oder Kohlenstoffaser wird ein radiales Abdrängen des Bohrers weitgehend verhindert, ohne daß an der Bohrungswandung große Reibungskräfte auftreten. Daher kann auf Führungsleisten weitgehend verzichtet werden, und selbst die Nebenschneiden bzw. Führungsfasern werden wesentlich entlastet. Der Bohrer kann daher nach hinten entsprechend verjüngt werden, was eine zusätzliche Reibungsminderung mit sich bringt.

Zweischneidenbohrer, die im übrigen der eingangs gegebenen Definition entsprechen und eine aus dem Bohrerkern herausgeformte Zentrierspitze aufweisen, zu der die als Zentrumsschneiden ausgebildeten innersten Teile wenigstens einer Stirnschneide geführt sind, zeigen bereits die Darstellungen in den Bildern 9 bis 11 der Zeitschrift «Technische Rundschau», Band 68, Nr. 46, vom November 1976. Dabei handelt es sich jedoch um einen Blechbohrer, der zum Bohren von dünnen Werkstücken aus einem weitgehend homogenen und weichen Werkstoff bestimmt ist. Zudem kann dort der meist von Hand geführte Bohrer kaum exakt senkrecht zur Werkstückoberfläche angesetzt werden. Daher ist ein Anzentrieren mittels exzentrisch zur Bohrerachse angeordneter Schneidspitzen nicht möglich, jedenfalls aber sehr unzweckmäßig.

Da das Anzentrieren notwendigerweise mit einer in der Bohrerachse angeordneten Zentrierspitze auszuführen ist, benötigt man bei auch dort vorhandenen exzentrischen Schneidspitzen eine in der Bohrerachse angeordnete Zentrierspitze, die aber deutlich über die Schneidspitzen hinausragen muß, um vor diesen am Werkstück zum Eingriff zu kommen. Eine solche vorstehende Zentrierspitze wird aber, bedingt durch die in der Bohrerachse vorherrschende Schnittgeschwindigkeit Null beim Auftreffen auf unebenen Flächen bzw. harten Fasern wie Glasfasern immer radial abweichen. Damit geht die angestrebte Positionsgenauigkeit bzw. Zentrierung verloren. Die später zum Eingriff kommenden exzentrischen Schneidspitzen können auch ein solches Verlaufen nicht mehr korrigieren, unabhängig davon, wieviele Schneidspitzen vorgesehen sind.

Die Anzentrierung mittels exzentrischer Schneidspitzen ist jedoch weitgehend problemlos dort möglich, wo der Bohrer exakt in seiner Bohrerachse geführt wird und auf eine radial ausgerichtete Werkstückoberfläche trifft, wie dies Voraussetzung zum Bohren von Leiterplatten ist. Dabei wird auch in Abhängigkeit der Anzahl der Schneidspitzen eine durchaus hinreichende Anfangsstabilisierung erzielt, und die einen Augenblick später zum Eingriff kommenden zurückversetzten Zentrumsschneiden an der Zentrierspitze unterstützen und verbessern die Stabilisierung, was anschließend wiederum durch die am Außendurchmesser vorgesehenen Führungselemente wie Führungsphasen bzw. Nebenschneiden verbessert werden kann. Die Erfindung ermöglicht daher auch bei größeren Bohrtiefen eine gleichbleibend gute Positionsgenauigkeit und sehr gute Oberflächen- und Rundlaufergebnisse.

Weitere Merkmale und Vorteile der Erfindung sind in den Unteransprüchen und in der nachstehenden Beschreibung mehrerer Ausführungsbeispiele anhand der Zeichnung herausgestellt. Es zeigen

Fig. 1 eine räumliche Darstellung eines erfindungsgemäßen Mehrschneidenbohrers,

Fig. 2 eine Stirnansicht dieses Bohrers,

Fig. 3 einen Schnitt nach der Linie III/III in Fig. 2,

Fig. 4 einen Teilschnitt gem. der Linie IV/IV in Fig. 2,

Fig. 5 einen solchen Teilschnitt längs der Linie V/V in Fig. 2,

Fig. 6 eine der Fig. 2 entsprechende Stirnansicht eines Vierschneidenbohrers,

Fig. 7 eine Seitenansicht des Bohrerendteiles und

Fig. 8 eine räumliche Darstellung der dort vorgesehenen Zentrierspitze.

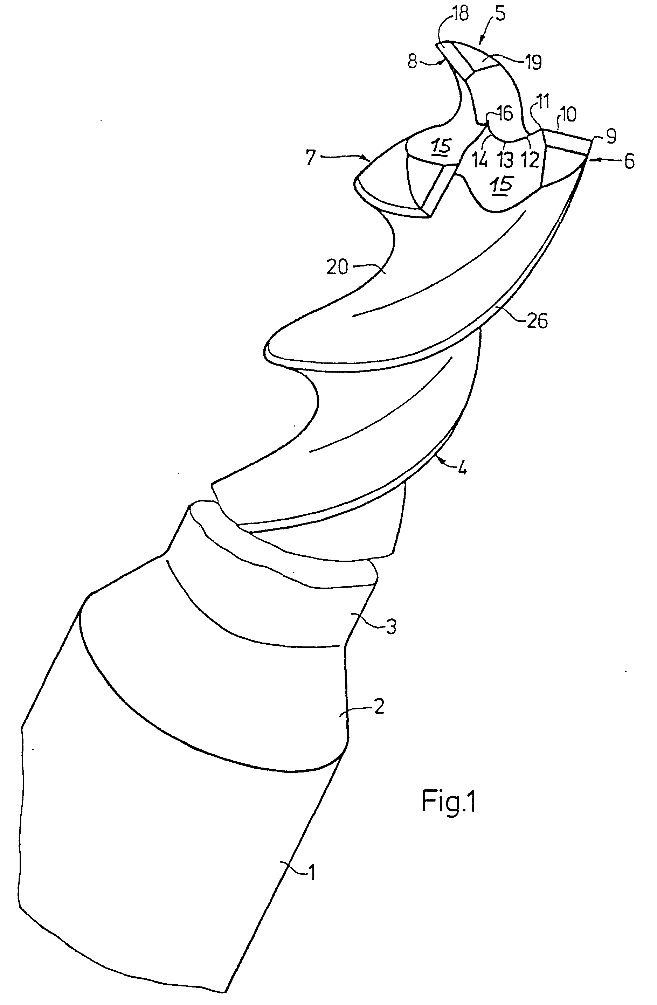

Der in Fig. 1 gezeigte Spiralbohrer ist mehrfach vergrößert dargestellt und weist einen verstärkten Einspannschaft 1 auf, an den sich über einen konischen Übergangsteil 2 ein zylindrischer Werkzeugschaft 3 mit Spiralenteil 4 anschließt.

Der ganze Bohrer kann einstückig aus Schneidwerkstoff wie Werkzeugstahl oder Hartmetall hergestellt sein. Es kann allerdings auch der Schneidwerkstoff in Form eines Vollkopf-Werkzeugteiles auf einen tragenden Schaft aus formstabilem Baustahl o.dgl. aufgelötet oder auf andere Weise auf diesem befestigt sein. Da der Bohrer insbesondere zum Bohren von Leiterplatten bestimmt ist, dürfte in der Regel als Schneidstoff mindestens Hartmetall eingesetzt werden, ggf. kommt auch polykristalliner Diamantwerkstoff o.dgl. ultraharter Schneidstoff wie kubisches Bornitrid in Betracht. Ausführungen mit gesondert eingesetzten Schneidplatten sind zwar grundsätzlich möglich, kommen aber weniger in Betracht.

Der dargestellte Bohrer weist unter gleicher Winkelteilung drei Schneidlippen 5, 6, 7 mit Hauptschneiden 8 und dazwischen gebildeten Spannuten 20 auf. Jede Spannut wird fortgesetzt durch eine Spitznut 15, die den inneren Teil der Hauptschneide 8 zwischen einer mittleren Zentrierspitze 16 in der Form einer Dreiecks-Pyramide und einer Schneidspitze 11 herausformt. Jede Schneidspitze der identisch ausgebildeten und achsensymmetrisch angeordneten Hauptschneiden trennt eine Außenschneide 10 mit äußerer Schneidenecke 9 von einer Innenschneide 12, die über einen gewölbten Schneidengrund 13 in eine zur Zentrierspitze 16 führende Zentrumsschneide 14 übergeht.

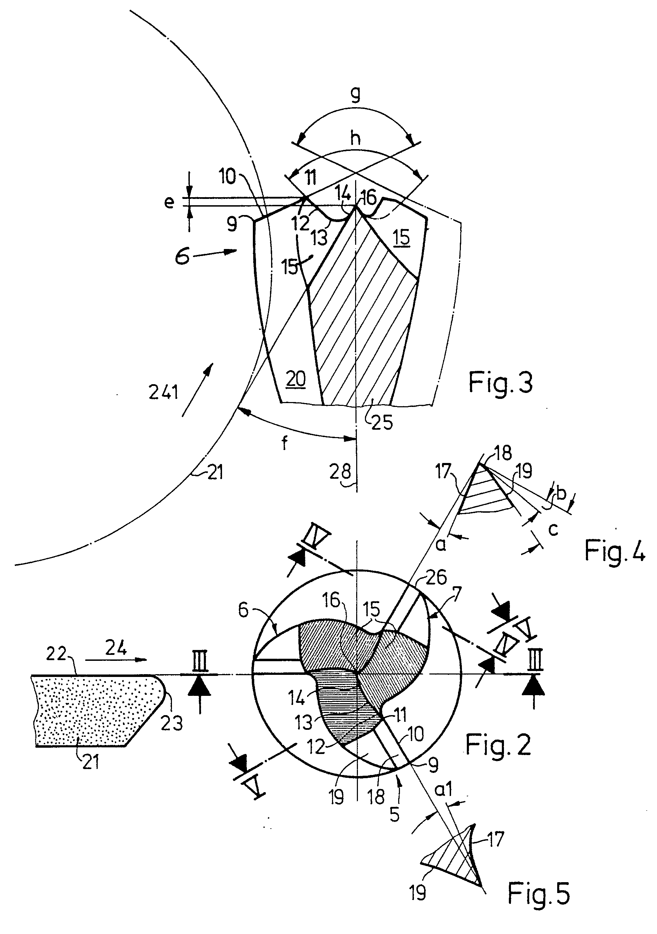

Wie vornehmlich aus Fig. 4 zu ersehen, bildet die Zahnbrust 17 an der Außenschneide 10 einen positiven Spanwinkel a, die Fase 18 einen ersten Freiwinkel b und der Zahnrücken 19 einen zweiten Freiwinkel c.

Eine Schleifscheibe 21, deren Durchmesser ca. 20mal größer ist als der Bohrerdurchmesser, wird mit ihrer ebenen Stirnseite 22 bei einer Umfangsrundung 23 parallel zur Brustfläche 17 im Bereich der Außenschneide 10 und an dieser in Richtung der Pfeile 24 und 241 (Fig. 2 und 3) so unter dem Winkel f zur Bohrerachse 28 durch die Spannut 20 hindurch in den Bohrerkern 25 eingefahren, daß sich identische Spitznuten 15 ergeben, die sich gemeinsam im freien Ende der Zentrierspitze 16 und ferner in den jeweils benachbarten Innenschneiden 12, Schneidengründen 13 und Zentrumsschneiden 14 treffen. Dabei können die Zentrumsschneiden unmittelbar in der Achse zusammenlaufen, aber auch etwas vor dieser geführt sein, wenn die Spitze etwas dreieckförmig abgestumpft ist. Der Spanwinkel nimmt aus der Größe a im Bereich der Außenschneide 10 von der Schneidspitze 11 bis zum Wert null im Bereich der Innenschneide 12 ab und erreicht dann Negativ-Werte, etwa den Wert a1 (Fig. 5) im Bereich des Schneidengrundes. Dieser negative Winkel wird entsprechend der Umfangsrundung 23 der Schleifscheibe 21 bis zur Zentrierspitze 16 hin noch weiter vergrößert, vom Schneiden wird dabei zum Schaben übergegangen.

Durch den positiven Spanwinkel an den Außenschneiden 10 ergibt sich dort wie auf dem weitaus größeren Teil des Bohrerdurchmessers verhältnismäßig geringer Bohrwiderstand, und auch das Abführen der Späne wird in den großvolumigen Spannuten 20 erleichtert. Dem kommt bei der Neigung der Außenschneiden 10 noch ein Ablösen der Späne nach innen zugute, wodurch die Späne vom Außenumfang weg leicht nach innen geleitet werden. Der Bohrwiderstand nimmt dann von außen nach innen mit entsprechender Änderung des Spanwinkels zu, so daß in der Zentrierspitze 16 ein zentrischer Vorschub- und Drehwiderstand erreicht wird, der zwar kleiner ist als bei einer herkömmlichen Querschneide eines Zweischneidenbohrers, aber doch eine vergleichbare Zentrierung ermöglicht. Diese mittlere Zentrierspitze 16 ist hier um die Strecke e gegenüber den Schneidspitzen 11 zurückversetzt. Dies empfiehlt sich vor allem für härtere Werkstücke oder Werkstücke mit sich von Ort zu Ort ändernden Festigkeitswerten, wie es faserverstärkte Leiterplatten nun einmal sind.

Dadurch kommen beim Ansetzen des Bohrers zunächst die Schneidspitzen 11 zum Eingriff und nehmen auch dann ein annehmbares Vorzentrieren oder Anzentrieren vor, wenn nicht alle Schneidspitzen exakt gleich weit vorragen bzw. überhaupt alle Hauptschneiden völlig identisch geformt und exakt achsensymmetrisch angeordnet sind. Wegen der anfangs geringen Schnittkräfte kann dabei kaum ein nachteiliges Auslenken auftreten. Sobald jedoch die Zentrierspitze 16 in das Werkstück eindringt, tritt nach sich verstärkendem Schnittwiderstand eine Laufberuhigung ein, und der Bohrer wird wesentlich besser gegen Auslenkkräfte gehalten. Die Nebenschneiden 26, bzw. Seitenfasen können daher unmittelbar die Führung des Bohrers im Werkstück mit verhältnismäßig kleiner radialer Anlagekraft und damit geringer Reibung bewerkstelligen. Daher lassen sich an Ein- und Austrittseite völlig gratfreie Bohrungen einbringen.

Nach diesem Ausführungsbeispiel ist davon ausgegangen, daß alle Hauptschneiden 10 auf der gleichen, zur Bohrerachse 28 zentrischen Rotationsfläche liegen, wobei die Außenschneiden 10 einen Spitzenwinkel g von 120–130° haben, während der Kegelwinkel h, der von der Umlauffläche der Innenschneiden 12 gebildet wird, etwa 80° beträgt. Je kleiner der Winkel h ist, umso größer ist die mittels Schneidspitzen 11 und Innenschneiden 12 erzielte Zentrierwirkung, was vornehmlich für den Anzentriervorgang von Bedeutung ist. Der von der Zentrierspitze 16 gebildete Spitzenwinkel hat hier die Größe 2f = etwa 60°. Dieser Wert hat sich deshalb als zweckmäßig herausgestellt, weil mit relativ geringem Eindringwiderstand hinreichende Zentrierwirkung verbunden ist.

Der Außendurchmesser des Spiralenteils 4 des Bohrers ist von den Schneidecken 9 weg nach hinten verjüngt, sodaß die Abstützung der Nebenschneiden 26 weitgehend dicht am freien Bohrerende erfolgt, von dort aber die Nebenschneiden stärkerwerdend entlastet sind. Durch die Wirkung der Zentrierspitze tritt jedoch eine radiale Stützentlastung unmittelbar im Bereich der Hauptschneiden auf.

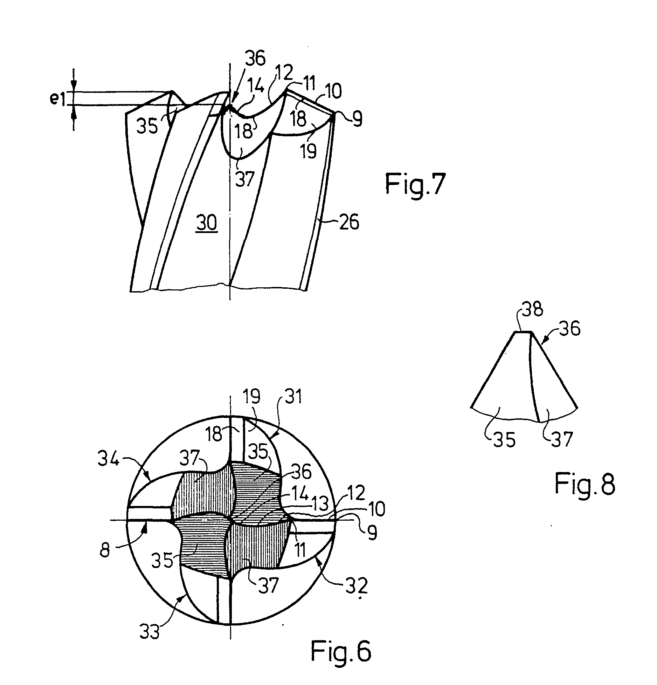

Bei dem in den Figuren 6 bis 8 gezeigten Vierschneidenbohrer haben die Stirnschneiden 8 in den Schneidlippen 31 bis 34 nahezu exakt die gleiche Form wie beim zuvor beschriebenen Dreischneidenbohrer. Daher sind auch für die Schneiden und Schneidenelemente in der Regel die gleichen Bezugzeichen eingesetzt. In der Form abweichend sind im Prinzip nur die Spannuten 30, die Spitznuten 35, 37 und die Zentrierspitze 36. Die Abweichungen sind maßgeblich durch den Übergang von drei Schneiden auf vier Schneiden bedingt. Es ist jedoch aus Fig. 6 erkennbar, daß die einander diametral gegenüberliegenden Spannuten (37) etwas weniger weit durchgeführt sind als die Spannuten (35).

Wie deutlich aus der vergrößerten Darstellung in Fig. 8 ersichtlich, erhält die Zentrierspitze (36) dadurch die Form eines pyramidenartigen Firstdaches und bildet eine Querschneide (38) aus, die eine Wirkung wie bei Zweilippenbohrern hat, also eine durchaus vergleichbare Zentrierwirkung bringt wie die Sternschneide der Zentrierspitze (16).

Besondere Bedeutung für den Spanfluß im mittleren Teil der Schneide kommt auch der Wölbung des Schneidengrundes (13) zu, weil diese ein Ableiten der im Bereich der Bohrerachse (28) vornehmlich abgeschabten Späne ermöglicht, ohne daß die Zentrierwirkung nachteilig beeinfluß werden kann.

Der axiale Abstand (Strecke e) zwischen Zentrierspitze und Schneidspitzen kann, den jeweiligen Werkstoffbedingungen angepaßt, zwischen 2 und 20% gewählt werden, wobei derzeit ca. 5 bis 12% bevorzugt werden. Es kann auch der Spitzenwinkel der Zentrierspitze umso kleiner gewählt werden, je weiter sie vorragt. Dieser Winkel ist, wie wohl Fig. 8 verdeutlicht, bei der Vierschneidenausführung kleiner als 60°, sollte aber möglichst 40° nicht unterschreiten.

Wie schon die Vierschneidenausführung zeigt, müssen nicht alle Hauptschneiden (8) bis zur Bohrerachse (28) durchgeführt werden. Im Prinzip reicht gar eine einzige Zentrumsschneide 14, nur könnten dadurch radiale Auslenkkräfte verursacht werden, die zusätzlich kompensiert werden müssten, und dies gelingt oft nicht.

Wenn auch nach derzeitiger Kenntnis dem Dreischneidenbohrer die größere Bedeutung zukommt, könnten ggf. auch mehr als vier Schneiden zum Einsatz kommen. In aller Regel geht es um Spiralbohrer, für Sonderzwecke können aber auch Bohrer mit achsparallel verlaufenden Kanten vorteilhaft zum Einsatz gebracht werden.

**Patentansprüche**

1. Mehrschneidenbohrer mit wenigstens drei von einem Bohrerkern (25) aus vorwiegend radial verlaufenden Stirnschneiden, die jeweils durch eine Schneidspitze (11) unterteilt sind in eine zur Bohrerachse (28) nach innen/vorn geneigte Außenschneide (10) und eine nach innen/hinten geneigte Innenschneide (12), mit an der Bohrerstirn angebrachten zusätzlichen Zentriermitteln, insbesondere zum Bohren von Werkstücken mit hoher, jedoch wechselnder Härte und Festigkeit wie faserverstärkte Leiterplatten, dadurch gekennzeichnet, daß die Zentriermittel eine aus dem Bohrerkern (25) herausgeformte, hinter die Schneidspitzen (11) zurückversetzte Zentrierspitze (16, 36) aufweisen, zu der die als Zentrumsschneiden (14) ausgebildeten innersten Teile wenigstens einer Stirnschneide (8) geführt sind.

2. Mehrschneidenbohrer nach Anspruch 1, dadurch gekennzeichnet, daß wenigstens zwei, insbesondere diametral gegenüberliegende Stirnschneiden (8) mit bis zur Zentrierspitze (36) durchgeführten Zentrumsschneiden (14) versehen sind.

3. Mehrschneidenbohrer nach Anspruch 1 oder 2, dadurch gekennzeichnet, daß die Zentrumsschneiden (14) wenigstens teilweise zur Zentrierspitze (16, 36) hin nach vorne ansteigen.

4. Mehrschneidenbohrer nach Anspruch 3, dadurch gekennzeichnet, daß die Stirnschneide (8) im Übergangsbereich zwischen Innenschneide (12) und Zentrumsschneide (14) einen konkav gewölbten Schneidengrund (13) bildet.

5. Mehrschneidenbohrer nach Anspruch 3 oder 4, dadurch gekennzeichnet, daß die Haupt- und Nebenschneiden (8) aufweisenden Schneidlippen (5-7, 31-34) ausgespitzt, bzw. die zwischen den Schneidlippen gebildeten Spannuten (20, 30) zur Zentrierspitze (16, 36) hin augeschliffen sind, wobei wenigstens eine Spitznut (15, 35, 37) bis dicht zur Bohrerachse (28) durchgeführt ist.

6. Mehrschneidenbohrer nach Anspruch 5, dadurch gekennzeichnet, daß mehrere achsensymmetrisch angeordnete Spitznuten (15, 35, 37) bis in die Zentrierspitze (16, 36) hineingeführt sind.

7. Mehrschneidenbohrer nach einem der Ansprüche 1 bis 6, dadurch gekennzeichnet, daß wenigstens die Außenschneiden (10) mit Schneidspitzen (11) und äußeren Schneidecken (9), insbesondere auch die Innenschneiden (12) und gegebenenfalls mehrere Zentrumsschneiden (14) auf der gleichen Umlauffläche liegen.

8. Mehrschneidenbohrer nach Anspruch 1, dadurch gekennzeichnet, daß der axiale Abstand (e, e1) der Zentrierspitze (16, 36) von den Schneidspitzen (11) zwischen 2 und 20 Prozent, insbesondere 5 und 12 Prozent des Bohrerdurchmessers liegt.

9. Mehrschneidenbohrer nach einem der Ansprüche 1 bis 8, dadurch gekennzeichnet, daß der Spitzenwinkel (2f) der Zentrierspitze (16, 36) umso kleiner ist, je weiter sie über den Schneidengrund (13) vorragt.

10. Mehrschneidenbohrer nach Anspruch 9, dadurch gekennzeichnet, daß der Spitzenwinkel (2f) der Zentrierspitze (16, 36) im Bereich 40 bis 120°, insbesondere 50 bis 80° liegt.

11. Mehrschneidenbohrer nach einem der Ansprüche 1 bis 10, gekennzeichnet durch die Ausbildung eines Endteiles der Zentrierspitze (36, 16) als Querschneide (38) oder Sternschneide.

**Claims**

1. Multi-edged drill-bit having at least three leading cutting edges, which mainly extend radially from a bit core (25) and are each divided by means of a cutting point (11) into an outer cutting edge (10), which is inclined inwardly and forwardly relative to the bit axis (28), and an inner cutting edge (12), which is inclined inwardly and rearwardly, having additional centering means mounted on the bit head, more especially for the drilling of workpieces having a high, but varying hardness and strength, such as fibre-reinforced printed circuit boards, characterised in that the centering means have a centering point (16, 36), which is moulded from the bit core (25) and is rearwardly offset behind the cutting points (11), the innermost portions of at least one leading cutting edge (8) being in the form of central cutting edges (14) and extending to the centering point.

2. Multi-edged drill-bit according to claim 1, characterised in that at least two leading cutting edges (8), which are more especially situated diametrically opposite each other, are provided with central cutting edges (14) which extend to the centering point (36).

3. Multi-edged drill-bit according to claim 1 or 2, characterised in that the central cutting edges (14) incline forwardly at least partially towards the centering point (16, 36).

4. Multi-edged drill-bit according to claim 3, characterised in that the leading cutting edge (8) forms a concavely curved cutting edge bottom (13) in the transitional region between the inner cutting edge (12) and the central cutting edge (14).

5. Multi-edged drill-bit according to claim 3 or 4, characterised in that the cutting lips (5–7, 31–34), having major and minor cutting edges (8), are cut-out, or respectively the chip grooves (20, 30), formed between the cutting lips, are ground-out so as to extend to the centering point (16, 36), at least one pointed groove (15, 35, 37) extending close to the bit axis (28).

6. Multi-edged drill-bit according to claim 5, characterised in that several pointed grooves (15, 35, 37), which are disposed in an axis-symmetrical manner, are provided as far as the centering point (16, 36).

7. Multi-edged drill-bit according to one of claims 1 to 6, characterised in that at least the outer cutting edges (10) with cutting points (11) and external cutting corners (9), more especially also the inner cutting edges (12) and possibly several central cutting edges (14) are situated on the same circumferential surface.

8. Multi-edged drill-bit according to claim 1, characterised in that the axial spacing (e, e1) between the centering point (16, 36) and the cutting points (11) lies between 2 and 20 per cent, more especially 5 and 12 per cent, of the bit diameter.

9. Multi-edged drill-bit according to one of claims 1 to 8, characterised in that the peak angle (2f) of the centering point (16, 36) is all the more smaller, the further it protrudes beyond the cutting edge bottom (13).

10. Multi-edged drill-bit according to claim 9, characterised in that the peak angle (2f) of the centering point (16, 36) lies in the range of between 40° and 120°, more especially between 50° and 80°.

11. Multi-edged drill-bit according to one of claims 1 to 10, characterised by the provision of an end portion of the centering point (36, 16) as a transverse cutting edge (38) or star cutting edge.

## Revendications

1. Foret à plusieurs arêtes tranchantes comportant au moins trois arêtes tranchantes frontales qui s'étendent principalement radialement à partir d'une âme de foret (25) et qui sont divisées chacune par une pointe d'arête tranchante (11) en une arête tranchante extérieure (10) inclinée vers l'intérieur/vers l'avant par rapport à l'axe (28) du foret et en une arête tranchante intérieure (12) inclinée vers l'intérieur/vers l'arrière, et des moyens de centrage supplémentaires ménagés sur la partie frontale de foret, en particulier pour percer des pièces de dureté et de résistance élevées mais changeantes, commes des plaquettes de circuit imprimé armées de fibres, caractérisé en ce que les moyens de centrage présentent une pointe de centrage (16, 36) qui est formée en relief par creusement, dans l'âme (25) du foret, qui est décalée en arrière par rapport aux pointes d'arêtes tranchantes (11) et à laquelle aboutissent les parties les plus intérieures, formées sous forme d'arêtes tranchantes centrales (14), d'au moins une arête tranchante frontale (8).

2. Foret à plusieurs arêtes tranchantes selon la revendication 1, caractérisé en ce qu'au moins deux arêtes tranchantes frontales (8), en particulier diamétralement opposées l'une à l'autre, sont pourvues d'arêtes tranchantes centrales (14) s'étendant jusqu'à la pointe de centrage (36).

3. Foret à plusieurs arêtes tranchantes selon la revendication 1 ou 2, caractérisé en ce que les arêtes tranchantes centrales (14) montent vers l'avant, au moins partiellement jusqu'à la pointe de centrage (16, 36).

4. Foret à plusieurs arêtes tranchantes selon la revendication 3, caractérisé en ce que l'arête tranchante frontale (8) forme, dans la zone de transition entre une arête tranchante intérieure (12) et une arête tranchante centrale (14), un fond (13) d'arête tranchante concave.

5. Foret à plusieurs arêtes tranchantes selon la revendication 3 ou 4, caractérisé en ce que des lèvres de coupes (5–7, 31–34) présentent les arêtes tranchantes principales et auxiliaires (8) sont amincies, respectivement des rainures à copeaux (20, 30), formées entre les lèvres de coupe sont taillées à la meule en direction de la pointe de centrage (16, 36), au moins une rainure de pointe (15, 35, 37) étant réalisée jusque très près de l'axe (28) du foret.

6. Foret à plusieurs arêtes tranchantes selon la revendication 5, caractérisé en ce que plusieurs rainures de pointe (15, 35, 37) disposées symétriquement par rapport à l'axe vont jusqu'à la pointe de centrage (16, 36).

7. Foret à plusieurs arêtes tranchantes selon l'une des revendications 1 à 6, caractérisé en ce qu'au moins les arêtes tranchantes extérieures (10) comportant des pointes d'arêtes tranchantes (11) et des points d'attaque extérieurs (9), en particulier aussi les arêtes tranchantes intérieures (12) et éventuellement plusieurs arêtes tranchantes centrales (14), sont situées sur la même surface de révolution.

8. Foret à plusieurs arêtes tranchantes selon la revendication 1, caractérisé en ce que la distance axiale (e, e1) entre la pointe de centrage (16, 36) et les pointes d'arête tranchantes (11) représente entre 2 et 20 pourcent, en particulier 5 et 12 pourcent, du diamètre du foret.

9. Foret à plusieurs arêtes tranchantes selon l'une des revendications 1 à 8, caractérisé en ce que l'angle de pointe (2f) de la pointe de centrage (16, 36) est d'autant plus faible qu'elle fait d'avantage saillie sur le fond (13) des arêtes tranchantes.

10. Foret à plusieurs arêtes tranchantes selon la revendication 9, caractérisé en ce que l'angle de pointe (2f) de la pointe de centrage (16, 36) est dans la plage de 40 à 120°, en particulier de 50 à 80°.

11. Foret à plusieurs arêtes tranchantes selon l'une des revendications 1 à 10, caractérisé en ce qu'une partie d'extrémité de la pointe de centrage (36, 16) est conçue sous la forme d'une arête tranchante transversale (38) ou d'une arête tranchante en étoile.

Fig.1

g

h

10

e

11

9

14 16

6

12

13

15

15

15

241

20

21

f

28

25

Fig. 3

17

18

19

b

a

c

Fig. 4

IV

26

7

6

16

15

III

III

22

24

14

13

11

23

12

10

Fig. 2

V

19

18

9

21

5

a1

19

17

Fig. 5

Fig.7

Fig.8

Fig.6